Europäisches Patentamt

**European Patent Office**

**Office européen des brevets**

(11) Numéro de publication: **0 267 253 B1**

(12) **FASCICULE DE BREVET EUROPEEN**

(45) Date de publication de fascicule du brevet: **15.04.92** (51) Int. Cl.⁵: **H03K 17/13**, H01F 7/18

(21) Numéro de dépôt: **87903334.8**

(22) Date de dépôt: **20.05.87**

(86) Numéro de dépôt internationale :
**PCT/FR87/00168**

(87) Numéro de publication internationale :
**WO 87/07456 (03.12.87 87/27)**

(54) **PROCEDE ET DISPOSITIF DE COMMANDE D'UN ELECTRO-AIMANT DONT L'EXCITATION, PAR UN COURANT PERIODIOUE MONOARCHE, PROVOOUE L'ACTIONNEMENT D'UNE PIECE MOBILE.**

(30) Priorité: **21.05.86 FR 8607191**

(43) Date de publication de la demande:
**18.05.88 Bulletin 88/20**

(45) Mention de la délivrance du brevet:
**15.04.92 Bulletin 92/16**

(84) Etats contractants désignés:
**DE GB IT NL**

(56) Documents cités:
**EP-A- 0 101 389     DE-A- 2 325 881**
**FR-A- 1 070 880     FR-A- 2 319 249**
**FR-A- 2 400 286     US-A- 3 329 837**

(73) Titulaire: **TELEMECANIOUE**
**43-45, Boulevard Franklin Roosevelt**
**F-92504 Rueil-Malmaison Cedex(FR)**

(72) Inventeur: **BATAILLE, Christian**
**19, rue de Versailles**
**F-92410 Ville d'Avray(FR)**
Inventeur: **BELBEL, Elie**
**11, rue des Econdeaux**
**F-93800 Epinay sur Seine(FR)**
Inventeur: **GAST, Jean-Noel**
**14, rue Paul Olivier**
**F-92500 Rueil Malmaison(FR)**
Inventeur: **LAURAIRE, Michel**
**43, rue du Capitaine Guynemer**
**F-92400 Courbevoie(FR)**

(74) Mandataire: **Marquer, Francis et al**
**Cabinet Moutard 35, Avenue Victor Hugo**
**F-78960 Voisins le Bretonneux(FR)**

## Description

La présente invention concerne un procédé et un dispositif de commande d'un électro-aimant dont l'excitation, par un courant périodique monoarche, tel qu'un courant redressé demi-onde, provoque l'actionnement d'une pièce mobile.

Elle s'applique notamment à la commande des électro-aimants utilisés dans les contacteurs électriques dont la fermeture est obtenue à la suite de l'excitation de la bobine de l'électro-aimant par un courant périodique du type susdit, cette excitation provoquant l'application des contacts mobiles du contacteur sur les courants fixes. Toutefois, l'invention ne se limite pas à ce type d'application. Elle peut, en effet, convenir à de nombreux autres dispositifs actionnés par un électro-aimant tels que, par exemple, des électrovannes.

Il s'avère que dons les dispositifs de ce genre, l'énergie mécanique communiquée à la partie mobile de l'électro-aimant pour provoquer l'actionnement de la partie mobile est variable selon l'angle de fermeture de l'interrupteur qui commande habituellement l'excitation de la bobine de l'électro-aimant, c'est-à-dire selon l'instant marquant le début de l'excitation, considéré dans la période correspondante du courant périodique.

On constate, en particulier, que cette énergie est maximum lorsque l'angle de fermeture est nul et qu'elle décroît au fur et à mesure que cet angle croît dans la fraction de la période considérée contenant une arche. Il s'ensuit que, dans certains dispositifs, si l'on ne dimensionne pas l'électro-aimant pour certains angles défavorables, l'actionnement recherché, par exemple la fermeture du contacteur, ne se produira pas, ou encore l'équipage mobile s'arrêtera avant l'écrasement total des contacts.

L'invention a donc plus particulièrement pour but de réduire le dimensionnement d'un tel électro-aimant et les inconvénients qui en résultent, notamment en matière de coût, d'encombrement et d'économie d'énergie.

Pour parvenir à ce résultat, l'invention propose plus particulièrement un procédé pour la commande d'un électro-aimant comprenant une bobine sur laquelle peut être appliqué un courant périodique monoarche provenant d'une source à la suite de l'émission d'un ordre de commande, en vue de provoquer un actionnement déterminé d'une pièce mobile, ce procédé comprenant, de façon analogue à une commande de commutation pour courant alternatif pleine onde d'un type connu, notamment par le brevet FR-A-2 400 286, à partir de l'instant où ledit ordre de commande a été émis :

- la détection des instants de passage à zéro de la tension de la source ; et
- l'application, à l'un de ces instants, du courant périodique à la bobine de l'électro-aimant.

Selon l'invention, ce procédé comprend la détection des passages à zéro par valeur décroissante de la tension de la source et l'application du courant monoarche à la bobine de l'électro-aimant à l'un desdits instants de passage à zéro par valeur décroissante.

- un organe de détection des instants de passage à zéro, par valeurs décroissantes, de la tension de la source ; et
- un dispositif de commutation commandé par ledit organe de détection pour délivrer au dispositif interrupteur un signal de fermeture lors de la détection d'un instant de passage à zéro par valeur décroissante qui suit l'ordre de commande d'excitation de la bobine.

Il apparaît donc que, selon ce procédé et ce dispositif, quel que soit l'instant où est émis l'ordre de commande, l'énergie communiquée à la partie mobile de l'électro-aimant sera optimale. Il en résulte une diminution de l'encombrement et du coût de l'électro-aimant.

Un mode d'exécution de l'invention sera décrit ci-après, à titre d'exemple non limitatif, avec référence aux dessins annexés, dans lesquels :

La figure 1 est le schéma de principe d'un dispositif de commande conforme à l'invention ;

La figure 2 est un diagramme représentatif des signaux électriques en différents points du circuit représenté sur la figure 1.

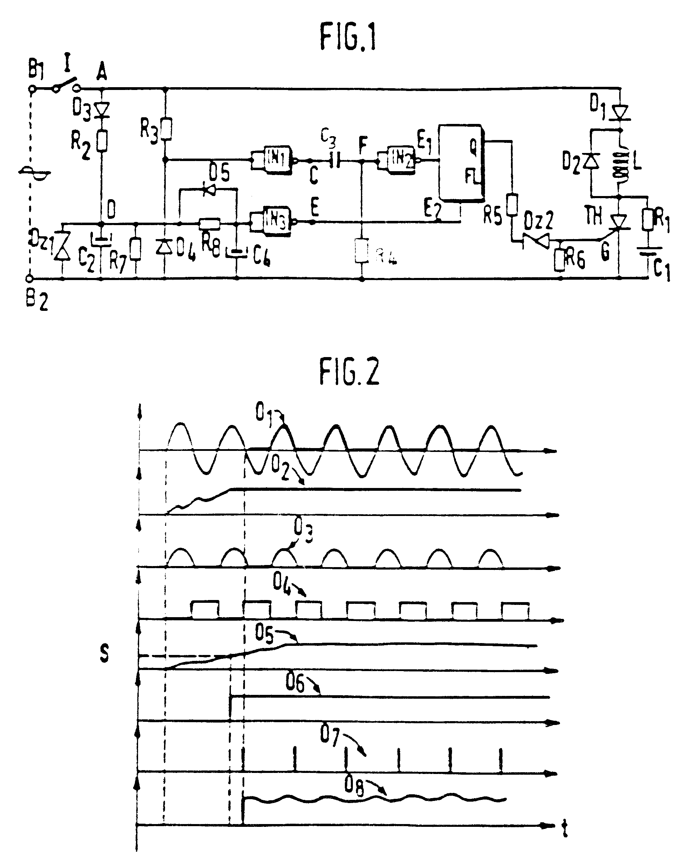

Tel que représenté sur la figure 1, le dispositif de commande pour électro-aimant dont seule la bobine L a été représentée fait intervenir, en série dans un circuit reliant la bobine L aux bornes d'une source de courant alternatif (bornes $B_1$, $B_2$), un interrupteur de commande I dont la fermeture est obtenue par application d'un ordre d'excitation de la bobine, une diode $D_1$ servant à réaliser un redressement simple alternance du courant alternatif et un dispositif interrupteur commandable constitué par un thyristor TH shunté, de façon classique, par une résistance $R_1$ en série avec un condensateur $C_1$. En parallèle avec la bobine L est également prévue une diode de roue libre $D_2$.

La gâchette G de ce thyristor est commandée par un circuit électronique de commande alimenté par un circuit d'alimentation connecté entre la borne de sortie A de l'interrupteur I et la borne $B_2$ de la source.

Ce circuit d'alimentation comprend notamment, en série, une diode $D_3$, une résistance $R_2$ et un condensateur $C_2$ shunté par une diode Zener $Dz_1$.

Dans cet exemple, la détection des zéro de la tension de la source en aval de l'interrupteur I est obtenue selon un processus comportant les étapes suivantes :

- l'obtention d'un courant redressé demi-onde synchrone du courant alternatif de la source et en phase avec celui-ci ;

- la conformation dudit courant redressé en un signal crénelé présentant les mêmes caractéristiques de fréquence, mais en opposition de phase ;
- la dérivation du signal crénelé de manière à obtenir des impulsions correspondant aux fronts montants dudit signal ;
- la commande de la gâchette G du thyristor par une bascule bistable sensible auxdites impulsions.

Ainsi, dans l'exemple représenté, la phase d'obtention du courant redressé est réalisée au moyen d'un circuit redresseur comprenant, entre les bornes A et $B_2$, une résistance $R_3$ et une diode $D_4$.

L'oscillogramme $O_3$ (figure 2) montre la tension redressée obtenue au point B, c'est-à-dire à la jonction entre la résistance $R_3$ et la diode $D_4$. Cette tension présente les mêmes caractéristiques de fréquence et de phase que la tension entre les bornes A, $B_2$ qui est représentée sur l'oscillogramme $O_1$ de la figure 2 (traits fins + traits épais).

La tension redressée demi-onde obtenue au point B est appliquée à un premier conformateur inverseur $IN_1$ qui délivre au point C un signal crénelé synchrone mais en opposition de phase, visible sur l'oscillogramme $O_4$. Ce signal est ensuite transmis à un dérivateur formé, de façon classique, par un condensateur $C_3$ et une résistance $R_4$. Au point F situé à la jonction du condensateur $C_3$ et de la résistance $R_4$, on obtient une succession d'impulsions qui correspondent respectivement aux fronts montants des créneaux du signal délivré par le conformateur inverseur $IN_1$ et, par conséquent, au passage à zéro par valeurs négatives de la tension redressée, simple alternance, délivrée par la diode $D_1$ (qui a été représentée en traits épais sur l'oscillogramme $O_1$).

Ces impulsions, visibles sur l'oscillogramme $O_7$, sont ensuite appliquées à un deuxième conformateur inverseur $IN_2$ dont la sortie est connectée à l'entrée $E_1$ d'une bascule bistable FL de type RS. La sortie Q de cette bascule FL, dont le signal est représenté par l'oscillogramme $O_8$, est connectée à la gâchette du thyristor TH par l'intermédiaire d'un circuit comprenant, en série, une résistance $R_5$ et une diode Zener $Dz_2$. Par ailleurs, la gâchette du thyristor TH est reliée à sa cathode par l'intermédiaire d'une résistance $R_6$.

L'entrée d'initialisation $E_2$ de la bascule FL est connectée à un circuit d'initialisation agencé de manière à n'émettre un signal d'initialisation que, lorsque, à la suite de la fermeture de l'interrupteur I, la tension d'alimentation dépasse une valeur prédéterminée. Ce circuit d'initialisation comprend plus particulièrement, entre le point D du circuit d'alimentation et la borne $B_2$, une résistance $R_8$ en série avec un condensateur $C_4$. Le point de jonction entre cette résistance $R_8$ et cette capacité $C_4$ est alors relié à un dispositif à seuil $IN_3$ qui délivre à sa sortie E une tension dont la variation a été représentée par l'oscillogramme $O_6$ et qui comprend, à la suite de l'instant de fermeture de l'interrupteur I, une première phase au cours de laquelle la tension présente une valeur nulle et une deuxième phase qui est déclenchée lorsque la tension à l'entrée du dispositif à seuil $IN_3$ (oscillogramme $O_5$) atteint un seuil prédéterminé S. Au cours de cette deuxième phase, la tension au point E présente une valeur correspondant à un état logique 1.

On obtient donc ainsi une temporisation de l'initialisation de la bascule FL qui permet d'éviter des perturbations lors de la phase transitoire qui suit la fermeture de l'interrupteur I.

Le circuit précédemment décrit comprend, en outre, une diode $D_5$ en parallèle avec la résistance $R_8$ qui sert à accélérer la décharge du condensateur $C_4$ lors de l'ouverture de l'interrupteur I.

Bien entendu, l'invention ne se limite pas à un type particulier d'interrupteurs commandables pour la commande de l'électro-aimant. Il est clair que le montage comprenant le thyristor TH et son circuit de commande pourraient être remplacés par tout autre montage produisant les mêmes effets.

Ainsi, la commande de l'électro-aimant pourrait également s'effectuer au moyen d'un optocoupleur comprenant, de façon classique, une diode électroluminescente montée dans le circuit de sortie de la bascule FL et un optothyristor monté dans le circuit de la bobine L.

## Revendications

1. Procédé pour la commande d'un électro-aimant comprenant une bobine sur laquelle est appliqué un courant périodique monoarche provenant d'une source à la suite de l'émission d'un ordre de commande, en vue de provoquer un actionnement déterminé d'une pièce mobile, ce procédé comprenant, à partir de l'instant où ledit ordre de commande a été émis, la détection des passages à zéro par valeur décroissante de la tension de la source et l'application du courant monoarche à la bobine de l'électro-aimant à l'un desdits instants de passage à zéro par valeur décroissante.

2. Procédé selon la revendication 1, caractérisé en ce que la détection des passages à zéro par valeur décroissante de la tension de la source est obtenue selon un processus comportant les étapes suivantes :

- l'obtention d'un courant redressé demi-onde synchrone du courant alternatif de la source et en phase avec celui-ci ;
- la conformation dudit courant redressé en un signal crénelé présentant les mêmes caractéristiques de fréquence mais en opposition de phase ;
- la dérivation du signal crénelé de manière à obtenir des impulsions de courant qui coïncident respectivement avec les fronts montants dudit signal ; et
- la commande de l'application du courant périodique sur la bobine par l'une desdites impulsions.

3. Dispositif pour la mise en oeuvre du procédé selon la revendication 1, ce dispositif servant à la commande d'un électro-aimant comprenant une bobine (L) alimentée en courant périodique monoarche, par l'intermédiaire d'un dispositif interrupteur commandable (TH) qui est commandé par un circuit de commande comprenant :
- un organe de détection des instants de passage à zéro par valeurs décroissantes de la tension de la source ($R_3$, $D_4$, $IN_1$, $R_4$, $C_3$) ; et
- un dispositif de commutation (FL) commandé par ledit organe de détection, pour délivrer à l'interrupteur (TH) un signal de fermeture lors de la détection d'un instant de passage à zéro par valeur décroissante qui suit l'ordre de commande d'excitation de la bobine (L).

4. Dispositif selon la revendication 3, dans lequel la bobine de l'électro-aimant est reliée à une source de courant alternatif par l'intermédiaire d'un premier circuit comprenant, en série, un interrupteur (I) dont la fermeture est obtenue par application d'un ordre d'excitation de la bobine, d'une diode ($D_1$) servant à obtenir le courant périodique monoarche, et d'un dispositif interrupteur commandable (TH), caractérisé en ce que la commande dudit interrupteur commandable (TH) est assurée au moyen d'un deuxième circuit reliant la sortie dudit interrupteur (I) à la borne de commande (G) du dispositif interrupteur commandable (TH), ce deuxième circuit comprenant :
- un redresseur ($R_3$, $D_4$) apte à fournir un courant redressé demi-onde synchrone du courant alternatif de la source et en phase avec celui-ci ;
- un conformateur ($IN_1$) apte à transformer le courant redressé en un signal crénelé présentant les mêmes caractéristiques de fréquence et en opposition de phase ;
- un dérivateur monté à la sortie du conformateur ($IN_1$), de manière à obtenir des impulsions correspondant aux fronts montants dudit signal ;
- une bascule bistable (FL) sensible auxdites impulsions dont la sortie effectue la commande dudit dispositif interrupteur commandable (TH).

5. Dispositif selon la revendication 4, caractérisé en ce qu'il comprend un circuit d'initialisation de la bascule bistable, ce circuit comprenant, en aval du susdit interrupteur (I), un circuit redresseur ($D_3$, $R_2$, $C_2$, $R_8$, $C_4$) et un dispositif à seuil ($IN_3$) qui fournit à la susdite bascule bistale (FL) un signal d'initialisation lorsque la tension délivrée par le circuit redresseur ($D_3$, $R_2$, $C_2$, $R_8$ $C_4$) dépasse un seuil prédéterminé, à la suite de la fermeture du susdit interrupteur (I).

6. Dispositif selon la revendication 3, caractérisé en ce que le susdit dispositif interrupteur commandable consiste en un thyristor (TH) dont la gâchette est commandée par le circuit de sortie de la bascule bistable (FL).

**Claims**

1. A method for controlling an electromagnet including a coil to which may be applied a monoarch periodic current coming from a source following the emission of a control order, for causing a given actuation of a mobile part, this method including, from the time when said control order has been emitted, detection of the zero cross-over times from a decreasing value of the voltage of the source, and the application, at one of said zero cross-over times from decreasing values of the monoarch current to the coil of the electromagnet.

2. Method according to claim 1, characterized in that detection of the zero cross-overs from decreasing values of the voltage of the source is obtained using a procedure including the following steps :
- the provision of a half-wave rectified current synchronous with the AC current of the source and in phase therewith ;
- shaping of said rectified current into a square wave signal having the same frequency, but in phase opposition ;
- shunting of the square wave signal so as to obtain current pulses which coincide respectively with the rising fronts of said signal, and
- controlling the application of the periodic current to the coil by means of said pulses.

3. A device for implementing the method according to claim 1, this device serving for controlling an electromagnet having a coil (L) supplied with a monoarch periodic current through a controllable switch device (TH), including :

- a member for detecting the zero crossover times from decreasing values of the voltage of the source ($R_3$, $D_4$, $IN_1$, $R_4$, $C_3$) ; and
- a switching device (FL) controlled by said detection member for delivering a closure signal to the switch device (TH) when a zero cross-over time from decreasing values is detected following the control order for energizing the coil (L).

4. Device according to claim 3, in which the coil of the electromagnet is connected to an AC source through a first circuit comprising, in series, a switch (I) whose closure is caused by application of an order for energizing the coil, a diode ($D_1$) for obtaining the monoarch periodic current and a controllable switch device (TH), characterized in that control of said controllable switch (TH) is provided by means of a second circuit connecting the output of said switch (I) to the control terminal ( G) of the controllable switch device (TH), this second circuit comprising :

- a rectifier ($R_3$, $D_4$) adapted for delivering a half-wave rectified current synchronous with the AC current of the source and in phase therewith ;
- a shaper ($IN_1$) adapted for transforming the rectified current into a square-wave signal having the same frequency characteristics and in phase opposition ;
- a shunting device mounted at the output of the shaper ($IN_1$) so as to obtain pulses corresponding to the rising fronts of said signal ;
- a bistable flip-flop (FL) responsive to said pulses whose output controls said controllable switch device (TH).

5. Device according to claim 4, characterized in that it comprises a circuit for initializing the bistable flip-flop, this circuit including, downstream of said switch (I), a rectifier circuit ($D_3$, $R_2$, $C_2$, $R_8$, $C_4$) and a threshold device ($IN_3$) which delivers an initialization signal to said bistable flip-flop (FL) when the voltage delivered by the rectifier circuit ($D_3$, $R_2$, $C_2$, $R_8$, $C_4$) exceeds a predetermined threshold, following closure of said switch (I).

6. Device according to claim 3, characterized in that said controllable switch device consists of a thyristor (TH) whose gate is controlled by the output circuit of the bistable flip-flop (FL).

**Patentansprüche**

1. Verfahren zur Ansteuerung eines Elektromagneten mit einer Spule, an die ein Halbwellenstrom aus einer Stromquelle angelegt wird, nach Abgabe eines Steuerbefehls, um eine bestimmte Betätigung eines beweglichen Stükkes hervorzurufen, wobei besagtes Verfahren vom Augenblick der Abgabe des besagten Befehls an besteht in:

- der Erfassung der Nulldurchgänge infolge abnehmender Werte der Quellenspannung und der Anlage des Halbwellenstroms an die Spule des Elektromagneten im Augenblick eines der Nulldurchgänge infolge abnehmender Werte.

2. Verfahren nach Anspruch 1, dadurch gekennzeichnet, dass die Erfassung der Nulldurchgänge infolge abnehmender Werte der Quellenspannung mittels eines Vorganges mit folgen Etappen erfolgt:

- Erzeugung eines gleichgerichteten, zum Wechselstrom der Quelle synchronen und mit diesem phasengleichen Halbwellenstroms,
  - Formung des besagten gleichgerichteten Stroms zu einem Rechtecksignal mit den gleichen Frequenzeigenschaften, aber in Gegenphase,
- Abzweigung des Rechtecksignals zur Erhaltung von Stromimpulsen, die jeweils mit den steigenden Fronten des besagten Signals übereinstimmen, und
- Befehl, durch einen der besagten Impulse den periodischen Strom an die Spule anzulegen.

3. Vorrichtung zur Ausfuhrung des Verfahrens nach Anspruch 1, wobei besagte Vorrichtung zur Ansteuerung eines Elektromagneten dient, der aufweist : eine Spule (L), die mit Halbwellenstrom gespeist wird, mittels einer Schaltvorrichtung (TH), die ein Steuerkreis ansteuert, mit:

- einem Organ zur Erfassung der Nulldurchgangszeiten infolge abnehmender Werte der Quellenspannung ($R_3$, $D_4$, $IN_1$, $R_4$, $C_3$) ; und
- einer von besagtem Erfassungorgan gesteuerten Schaltvorrichtung (FL), um dem Schalter (TH) ein Schliesssignal zugehen zu lassen, wenn, nach einem Befehl, die Spule (L) zu erregen, ein Nulldurchgangsmoment infolge abnehmender Werte erfasst wurde.

4. Vorrichtung nach Anspruch 3, in welcher die Spule des Elektromagneten an eine Wechselstromquelle angeschlossen ist, durch einen ersten Schaltkreis, der in Reihe aufweist: einen Schalter (I), dessen Schliessung durch Anlage eines Befehls die Spule zu erregen erreicht wird, eine Diode ($D_1$) zur Erhaltung des Halbwellenstroms, und eine steuerbare Schaltvorrichtung (TH),
dadurch gekennzeichnet, dass die Steuerung des besagten steuerbaren Schalters (TH) durch einen zweiten Schaltkreis erfolgt, der den Ausgang des besagten Schalters (I) mit der Steuerklemme (G) der steuerbaren Schaltvorrichtung (TH) verbindet, und besagter zweiter Schaltkreis aufweist:

- einen Gleichrichter ($R_3$, $D_4$), welcher einen gleichgerichteten, zum Wechselstrom der Quelle synchronen und mit diesem phasengleichen Halbwellenstrom liefern kann,
- einen Former ($IN_1$), welcher den gleichgerichteten Strom zu einem Rechtecksignal formt, welches die gleichen Frequenzeigenschaften besitzt und in Gegenphase ist,
- eine am Ausgang des Formers ($IN_1$) angeordnete Abzweigvorrichtung, um den steigenden Fronten des besagten Signals entsprechende Impulse zu erhalten,
- ein bistabiles, auf besagte Impulse ansprechendes Flip-Flop (FL), dessen Ausgang besagte steuerbare Schaltvorrichtung (TH) steuert.

5. Vorrichtung nach Anspruch 4,
dadurch gekennzeichnet, dass sie eine Initialisierschaltung für das bistabile Flip-Flop aufweist, und diese Schaltung unterhalb des besagten Schalters (I) eine Gleichrichteschaltung ($D_3$, $R_2$, $C_2$, $R_8$, $C_4$) aufweist und eine Schwellenvorrichtung ($IN_3$), welche dem besagten bistabilen Flip-Flop (FL) ein Initialisiersignal zugehen lässt, wenn die von der Gleichrichteschaltung ($D_3$, $R_2$, $C_2$ $R_8$, $D_4$) abgegebene Spannung infolge der Schliessung des besagten Schalters (I) einen bestimmten Schwellenwert überschreitet.

6. Vorrichtung nach Anspruch 3,
dadurch gekennzeichnet, dass besagte steuerbare Schaltvorrichtung aus einem Thyristor (TH) besteht, dessen Gate von der Ausgangsschaltung des bistabilen Flip-Flops gesteuert wird.

FIG.1

FIG.2